# EUROPEAN PATENT APPLICATION

(11) **EP 1 624 501 A2**
(43) Date of publication of application: **08.02.2006**
(21) Application number: 05016516.6
(22) Date of filing: 29.07.2005
(51) Int. Cl.: H01L 51/30

(54) **Organic electroluminescent device**

(30) Priority: 04.08.2004 JP 2004228475
(71) Applicant: LG Electronics, Inc., Seoul (KR); Chisso Corporation, Osaka-shi Osaka (JP)
(72) Inventor: Uchida, Manabu, Ichihara-shi, Chiba 290-8551 (JP); Wang, Guofang, Ichihara-shi, Chiba 290-8551 (JP); Kageyama, Akiko, Ichihara-shi, Chiba 290-8551 (JP); Lee, Kyung Hoon, Woomyeon-Dong, Seocho-Gu, Seoul 137-724 (KR); Lee, Jae Man, Woomyeon-Dong, Seocho-Gu, Seoul 137-724 (KR); Park, Chun Gun, Woomyeon-Dong, Seocho-Gu, Seoul 137-724 (KR)
(74) Representative: Zech, Stefan Markus

(57) **Abstract**

A phosphorescent device with high brightness and a long usable life including at least an emitting layer situated between a pair of electrodes and at least one hole blocking layer in direct contact with the emitting layer, wherein the phosphorescent device employs as the hole blocking layer, a compound which can be used as a blue luminescent host material.

## Description

### BACKGROUND OF THE INVENTION

### Field of the Invention

The present invention relates to an organic electroluminescent device, and more specifically to an organic electroluminescent device with high brightness and long usable life which utilizes phosphorescence (which will hereinafter be referred to simply as "phosphorescent device").

### Related Background Art

Phosphorescent devices composed of multilayer laminated structures are already known (US Patent No. 6,097,147). The theoretical threshold of internal quantum efficiency for fluorescent devices is 25% with luminescence from an excited singlet state, i.e. when light is emitted utilizing fluorescence alone, but since the excitation energy of the triplet state also contributes to luminescence, the theoretical threshold of internal quantum efficiency for phosphorescent devices may be considered 100%. Phosphorescent devices can therefore improve luminous efficiency as compared to fluorescent devices, which is the proportion of luminous brightness with respect to driving voltage.

In order to improve the luminous efficiency of and enhance the driving stability of organic electroluminescent devices at the same time, it has been proposed to provide between the emitting layer and electrodes a hole blocking layer which restricts migration of holes from the emitting layer. The hole blocking layer results in efficient accumulation of holes in the emitting layer, thereby improving the recombination rate with electrons and allowing higher luminous efficiency to be achieved. Phenanthroline derivatives (JP-A H10-79297/1998) and triazole derivatives (JP-A H10-233284/1998) have been reported as effective hole blocking materials. Further, Phenanthroline derivatives (Appl. Phys. Lett. 75, 4 (1999)) and aluminum chelate such as BAlq (Proc. SPIE, Vol. 4105, p175-182 (2000)) have been employed as hole blocking layers in phosphorescent devices.

### SUMMARY OF THE INVENTION

Even when such hole blocking materials are used, however, it is not always possible to obtain a phosphorescent device with adequate luminous efficiency and long usable life. When a phenanthroline derivative is used, it is said that the efficiency of the phosphorescent device is improved, however, driving stability is lowered. On the other hand, when Balq is used, it is said that driving stability is improved, however, the efficiency is lowered. Accordingly, it is desired to provide a phosphorescent device having an excellent driving stability and efficiency at the same time.
It is an object of the present invention to use specific compounds for the hole blocking layer in order to solve the problem referred to above and obtain a phosphorescent device with high luminous efficiency and a long usable life.

As a result of ongoing diligent research, the present inventors have accomplished this invention upon finding that the problem described above can be solved by using compounds which can serve as blue luminescent materials, and particularly specific anthracene derivatives, as hole blocking materials. More particularly, the invention has the following construction.

1. A phosphorescent device comprising at least an emitting layer situated between a pair of electrodes and at least one hole blocking layer in direct contact with the emitting layer, wherein the phosphorescent device employs as the hole blocking layer, a compound which can be used as a blue luminescent host material.

2. A phosphorescent device according to item 1, which comprises at least an electron transport layer, a hole blocking layer, an emitting layer, a hole transport layer and a hole injection layer, situated between a pair of electrodes.

3. A phosphorescent device according to item 1 or 2, wherein the compound which can be used as a blue luminescent host material is at least one type of compounds represented by formula (F11) and having a molecular weight of 340 or greater:

Ant(A)ₜ (F11)

wherein Ant is an anthracene ring of valence t, t is an integer of 1 to 10, and each A is independently any one of sets (a1) to (a6) below, with the proviso that (a6) is a group which coexists with at least one group from among sets (a1) to (a5) :
(a1) : a monovalent C6-130 substituted or unsubstituted unfused cyclic hydrocarbon group wherein the substituents include no heterocyclic groups;
(a2): a monovalent C6-130 substituted unfused cyclic hydrocarbon group wherein the substituents include heterocyclic groups;
(a3): a monovalent C10-130 substituted or unsubstituted fused cyclic hydrocarbon group wherein the substituents include no heterocyclic groups;
(a4): a monovalent C10-130 substituted fused cyclic hydrocarbon group wherein the substituents include heterocyclic groups;
(a5): a monovalent Cl-130 substituted or unsubstituted heterocyclic group wherein the atom directly bonded to the anthracene ring is an atom other than nitrogen; and
(a6): a monovalent C1-50 acyclic hydrocarbon group.

4. A phosphorescent device according to item 3, wherein at least one A in formula (F11) is a group represented by (a1).

5. A phosphorescent device according to item 3, wherein at least one A in formula (F11) is a group represented by (a2).

6. A phosphorescent device according to item 3, wherein at least one A in formula (F11) is a group represented by (a3).

7. A phosphorescent device according to item 3, wherein at least one A in formula (F11) is a group represented by (a4).

8. A phosphorescent device according to item 3, wherein at least one A in formula (F11) is a group represented by (a5).

9. A phosphorescent device according to item 3, wherein at least one A in formula (F11) is a group represented by (a6), and at least one A is a group represented by any one of (a1) to (a5).

10. A phosphorescent device according to item 4, wherein (a1) is a group comprising 1-10 substituted or unsubstituted benzene rings.

11. A phosphorescent device according to item 6, wherein (a3) is a group comprising 1-10 rings selected from among substituted or unsubstituted naphthalene rings, anthracene rings, phenanthrene rings, pyrene rings, and fluorene rings.

12. A phosphorescent device according to item 8, wherein (a5) is a group comprising 1-10 rings selected from among the following substituted or unsubstituted heterocycles: 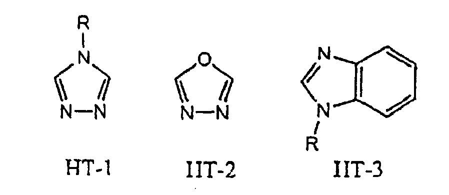 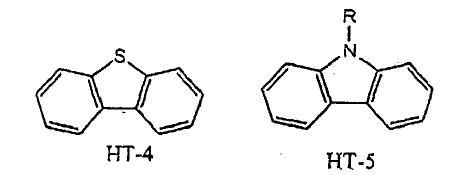 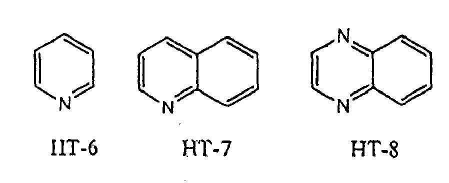 wherein R represents hydrogen, C1-6 alkyl or C6-18 aryl.

13. A phosphorescent device according to any one of items 10 to 12, wherein the substituents of A are groups comprising 1-10 rings or groups selected from among substituted or unsubstituted benzene rings, naphthalene rings, anthracene rings, phenanthrene rings, pyrene rings, fluorene rings, and the following rings: 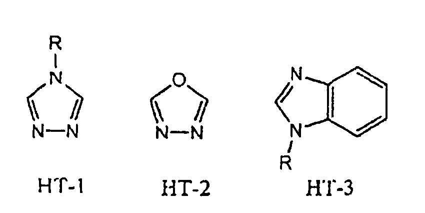 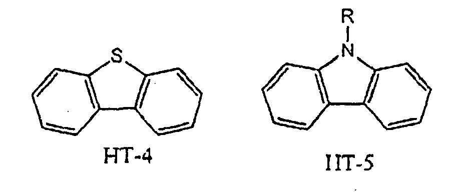 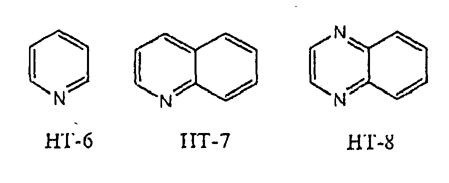 wherein R represents hydrogen, C1-6 alkyl or C6-18 aryl, as well as from phenylethenyl and diphenylethenyl.

14. A phosphorescent device according to any one of items 10 to 12, wherein the substituents of the substituents of A are C1-12 alkyl, with any methylene among the alkyls being optionally replaced with -O- and any methylene other than the 1-position methylene being optionally replaced with C6-12 arylene or C3-12 cycloalkylene.

15. A phosphorescent device according to item 13, wherein the substituents of the substituents of A are C1-12 alkyl, phenylethenyl or diphenylethenyl, with any methylene among the alkyls being optionally replaced with -O- and any methylene other than the 1-position methylene being optionally replaced with C6-12 arylene or C3-12 cycloalkylene.

16. A phosphorescent device according to any one of items 3 to 15, wherein A consists of at least two different groups selected from among (a1), (a2), (a3), (a4), (a5) and (a6).

17. A phosphorescent device according to items 4 or 10, wherein A consists of (a1) alone.

18. A phosphorescent device according to item 6 or 11, wherein A consists of (a3) alone.

19. A phosphorescent device according to item 4, 6, 10, 11 or 16, wherein A consists of (a1) and (a3) alone.

20. A phosphorescent device according to any one of items 3 to 19, wherein two A's are bonded at the 9- and 10-positions of Ant.

21. A phosphorescent device according to any one of items 3 to 20, wherein t=2.

22. A phosphorescent device according to any one of items 3 to 20, wherein t=3.

23. A phosphorescent device according to any one of items 3 to 20, wherein t=4-10.

24. A phosphorescent device according to item 3, wherein, in formula (F11), t=1 and A is a substituted phenyl, with at least a hydrogen on the phenyl being optionally replaced with at least one member selected from the group consisting of phenyl, biphenyl, terphenyl, naphthyl, anthryl, phenanthryl, fluorenyl, pyrenyl, benzyl, pyridyl, carbazolyl, benzimidazolyl, quinolyl and quinoxalyl.

25. A phosphorescent device according to item 3, wherein, in formula (F11), t=1 and A is naphthyl, anthryl, phenanthryl or a group, with at least a hydrogen on a group selected from these groups being optionally replaced with at least one member selected from the group consisting of methyl, ethyl, t-butyl, methoxy, ethoxy, phenyl, biphenyl, terphenyl, phenylethenyl, diphenylethenyl, naphthyl, anthryl, phenanthryl, fluorenyl, pyrenyl, benzyl, pyridyl, carbazolyl, benzimidazolyl, quinolyl and quinoxalyl.

26. A phosphorescent device according to item 24 or 25, wherein the number of the substituents is one to three.

27. A phosphorescent device according to item 3, wherein, in formula (F11), t=1 and A is a substituted phenyl, with four hydrogens on the phenyl being optionally replaced with at least one member selected from the group consisting of phenyl, biphenyl, terphenyl, naphthyl, anthryl, phenanthryl, fluorenyl, pyrenyl, benzyl, pyridyl, carbazolyl, benzimidazolyl, quinolyl and quinoxalyl.

28. A phosphorescent device according to item 3, wherein, in formula (F11), t=1 and A is naphthyl, anthryl, phenanthryl or a group, with four hydrogens on a group selected from these groups being optionally replaced with at least one member selected from the group consisting of methyl, ethyl, t-butyl, methoxy, ethoxy, phenyl, biphenyl, terphenyl, phenylethenyl, diphenylethenyl, naphthyl, anthryl, phenanthryl, fluorenyl, pyrenyl, benzyl, pyridyl, carbazolyl, benzimidazolyl, quinolyl and quinoxalyl.

29. A phosphorescent device according to any one of items 24 to 28, wherein A is bonded at the 9- or 10-positions of Ant.

30. A phosphorescent device according to item 3, wherein, in formula (F11), t=2 and one of A's is a substituted phenyl, with at least a hydrogen on the phenyl being optionally replaced with at least one member selected from the group consisting of phenyl, biphenyl, terphenyl, phenylethenyl, diphenylethenyl, naphthyl, anthryl, phenanthryl, fluorenyl, pyrenyl, benzyl, pyridyl, carbazolyl, benzimidazolyl, quinolyl and quinoxalyl, and the other of A's is phenyl, naphthyl, anthryl, phenanthryl or a group, with at least a hydrogen on a group selected from these groups being optionally replaced with at least one member selected from the group consisting of methyl, ethyl, t-butyl, methoxy, ethoxy, phenyl, biphenyl, terphenyl, phenylethenyl, diphenylethenyl, naphthyl, anthryl, phenanthryl, fluorenyl, pyrenyl, benzyl, pyridyl, carbazolyl, benzimidazolyl, quinolyl and quinoxalyl.

31. A phosphorescent device according to item 3, wherein, in formula (F11), t=2 and one of A's is naphthyl, anthryl, phenanthryl or a group, with at least a hydrogen on a group selected from these groups being optionally replaced with at least one member selected from the group consisting of methyl, ethyl, t-butyl, methoxy, ethoxy, phenyl, biphenyl, terphenyl, phenylethenyl, diphenylethenyl, naphthyl, anthryl, phenanthryl, fluorenyl, pyrenyl, benzyl, pyridyl, carbazolyl, benzimidazolyl, quinolyl and quinoxalyl, and the other of A's is phenyl, naphthyl, anthryl, phenanthryl or a group, with at least a hydrogen on a group selected from these groups being optionally replaced with at least one member selected from the group consisting of methyl, ethyl, t-butyl, methoxy, ethoxy, phenyl, biphenyl, terphenyl, phenylethenyl, diphenylethenyl, naphthyl, anthryl, phenanthryl, fluorenyl, pyrenyl, benzyl, pyridyl, carbazolyl, benzimidazolyl, quinolyl and quinoxalyl.

32. A phosphorescent device according to item 30 or 31, wherein the number of the substituents is one to three.

33. A phosphorescent device according to item 3, wherein, in formula (F11), t=2 and one of A's is a substituted phenyl, with four hydrogens on the phenyl being optionally replaced with at least one member selected from the group consisting of phenyl, biphenyl, terphenyl, naphthyl, anthryl, phenanthryl, fluorenyl, pyrenyl, benzyl, pyridyl, carbazolyl, benzimidazolyl, quinolyl and quinoxalyl, and the other of A's is phenyl, naphthyl, anthryl, phenanthryl or a group, with one to four hydrogens on a group selected from these groups being optionally replaced with at least one member selected from the group consisting of methyl, ethyl, t-butyl, methoxy, ethoxy, phenyl, biphenyl, terphenyl, phenylethenyl, diphenylethenyl, naphthyl, anthryl, phenanthryl, fluorenyl, pyrenyl, benzyl, pyridyl, carbazolyl, benzimidazolyl, quinolyl and quinoxalyl.

34. A phosphorescent device according to item 3, wherein, in formula (F11), t=2 and one of A's is a group, with four hydrogens on a group selected from naphthyl, anthryl and phenanthryl being optionally replaced with at least one member selected from the group consisting of methyl, ethyl, t-butyl, methoxy, ethoxy, phenyl, biphenyl, terphenyl, phenylethenyl, diphenylethenyl, naphthyl, anthryl, phenanthryl, fluorenyl, pyrenyl, benzyl, pyridyl, carbazolyl, benzimidazolyl, quinolyl and quinoxalil, and the other of A's is phenyl, naphthyl, anthryl, phenanthryl, pyridyl or a group, with one to four hydrogens on a group selected from these groups being optionally replaced with at least one member selected from the group consisting of methyl, ethyl, t-butyl, methoxy, ethoxy, phenyl, biphenyl, terphenyl, phenylethenyl, diphenylethenyl, naphthyl, anthryl, phenanthryl, fluorenyl, pyrenyl, benzyl, pyridyl, carbazolyl, benzimidazolyl, quinolyl and quinoxalyl.

35. A phosphorescent device according to any one of items 30 to 34, wherein two A's are bonded at the 9- and 10-positions of Ant.

36. A phosphorescent device according to item 3, wherein, in formula (F11), t=3 and one of A's is a substituted phenyl, with at least a hydrogen on the phenyl being optionally replaced with at least one member selected from the group consisting of phenyl, biphenyl, terphenyl, phenylethenyl, diphenylethenyl, naphthyl, anthryl, phenanthryl, fluorenyl, pyrenyl, benzyl, pyridyl, carbazolyl, benzimidazolyl, quinolyl and quinoxalyl, and the other two A's are independently phenyl, naphthyl, anthryl, phenanthryl or groups, with at least a hydrogen on a group selected from these groups being optionally replaced with at least one member selected from the group consisted of methyl, ethyl, t-butyl, methoxy, ethoxy, phenyl, biphenyl, terphenyl, phenylethenyl, diphenylethenyl, naphthyl, anthryl, phenanthryl, fluorenyl, pyrenyl, benzyl, pyridyl, carbazolyl, benzimidazolyl, quinolyl and quinoxalyl.

37. A phosphorescent device according to item 3, wherein, in formula (F11), t=3 and one of A's is naphthyl, anthryl phenanthryl or a group, with at least a hydrogen on a group selected from these groups being optionally replaced with at least one member selected from the group consisting of methyl, ethyl, t-butyl, methoxy, ethoxy, phenyl, biphenyl, terphenyl, phenylethenyl, diphenylethenyl, naphthyl, anthryl, phenanthryl, fluorenyl, pyrenyl, benzyl, pyridyl, carbazolyl, benzimidazolyl, quinolyl and quinoxalyl, and the other two A's are independently phenyl, naphthyl, anthryl, phenanthryl or groups, with at least a hydrogen on a group selected from these groups being optionally replaced with at least one member selected from the group consisting of methyl, ethyl, t-butyl, methoxy, ethoxy, phenyl, biphenyl, terphenyl, phenylethenyl, diphenylethenyl, naphthyl, anthryl, phenanthryl, fluorenyl, pyrenyl, benzyl, pyridyl, carbazolyl, benzimidazolyl, quinolyl and quinoxalyl.

38. A phosphorescent device according to item 36 or 37, wherein the number of the substituents is one to three.

39. A phosphorescent device according to item 3, wherein, in formula (F11), t=3 and one of A's is a substituted phenyl, with four hydrogens on the phenyl being optionally replaced with at least one member selected from the group consisting of phenyl, biphenyl, terphenyl, naphthyl, anthryl, phenanthryl, fluorenyl, pyrenyl, benzyl, pyridyl, carbazolyl, benzimidazolyl, quinolyl and quinoxalyl, and the other two A's are independently phenyl, naphthyl, anthryl, phenanthryl or a group, with one to four hydrogens on a group selected from these groups being optionally replaced with at least one member selected from the group consisting of methyl, ethyl, t-butyl, methoxy, ethoxy, phenyl, biphenyl, terphenyl, phenylethenyl, diphenylethenyl, naphthyl, anthryl, phenanthryl, fluorenyl, pyrenyl, benzyl, pyridyl, carbazolyl, benzimidazolyl, quinolyl and quinoxalyl.

40. A phosphorescent device according to item 3, wherein, in formula (F11), t=3 and one of A's is a group, with four hydrogens on a group selected from naphthyl, anthryl and phenanthryl being optionally replaced with at least one member selected from the group consisting of methyl, ethyl, t-butyl, methoxy, ethoxy, phenyl, biphenyl, terphenyl, phenylethenyl, diphenylethenyl, naphthyl, anthryl, phenanthryl, fluorenyl, pyrenyl, benzyl, pyridyl, carbazolyl, benzimidazolyl, quinolyl and quinoxalyl, and the other two A's are independently phenyl, naphthyl, anthryl, phenanthryl or a group, with one to four hydrogen on a group selected from these groups being optionally replaced with at least one member selected from the group consisting of methyl, ethyl, t-butyl, methoxy, ethoxy, phenyl, biphenyl, terphenyl, phenylethenyl, diphenylethenyl, naphthyl, anthryl, phenanthryl, fluorenyl, pyrenyl, benzyl, pyridyl, carbazolyl, benzimidazolyl, quinolyl and quinoxalyl.

41. A phosphorescent device according to any one of items 36 to 40, wherein two A's are bonded at the 9- and 10-positions of Ant.

42. A phosphorescent device according to any one of items 30 to 35, wherein two A's have each independently one or two substituents which are independently biphenyl, terphenyl, phenylethenyl, diphenylethenyl, naphthyl, anthryl, phenanthryl, fluorenyl or pyrenyl.

43. A phosphorescent device according to any one of items 36 to 41, wherein three A's have each independently one or two substituents which are independently biphenyl, terphenyl, phenylethenyl, diphenylethenyl, naphthyl, anthryl, phenanthryl, fluorenyl or pyrenyl.

44. A phosphorescent device according to item 3, wherein in formula (F11), t=2 and two A's are each independently phenyl, naphthyl, anthryl, phenanthryl, fluorenyl or pyrenyl, and have each independently one or two substituents which are independently biphenyl, terphenyl, phenylethenyl, diphenylethenyl, naphthyl, anthryl, phenanthryl, fluorenyl or pyrenyl.

45. A phosphorescent device according to item 3, wherein in formula (F11), t=3 and three A's are each independently phenyl, naphthyl, anthryl, phenanthryl, fluorenyl or pyrenyl, and have each independently one or two substituents which are independently biphenyl, terphenyl, phenylethenyl, diphenylethenyl, naphthyl, anthryl, phenanthryl, fluorenyl or pyrenyl.

The present invention employs blue luminescent materials, and particularly anthracene derivatives having specific structures, for hole blocking layers in order to increase luminous efficiency and impart a longer usable life to phosphorescent devices.

### DESCRIPTION OF THE PREFERRED EMBODIMENTS

The phosphorescent device of the invention is a phosphorescent device comprising at least an emitting layer situated between a pair of electrodes and at least one hole blocking layer in direct contact therewith, and it is preferably a phosphorescent device having a cathode, an electron transport layer, a hole blocking layer, an emitting layer, a hole transport layer, a hole injection layer and an anode laminated in that order.

The invention is characterized in that the aforementioned hole blocking layer contains a compound which can be used as a blue luminescent host material particularly, an anthracene derivative represented by formula (F11) above.
The anthracene derivative represented by formula (F11) may have 1-10 substituents according to substituent A. Substituent A is largely divided into 6 sets, (a1) to (a6). Of these, (a1) to (a5) are cyclic groups, and only (a6) is an acyclic hydrocarbon group. However, in order to ensure that (a6) will coexist with at least one group from among (a1) to (a5), at least one substituent of the anthracene ring is a cyclic hydrocarbon group.

Set (a1) comprises a C6-130 substituted or unsubstituted unfused cyclic hydrocarbon group. Unfused cyclic hydrocarbon groups include substituted and unsubstituted benzene rings, cycloalkane rings, crosslinked cyclic hydrocarbon groups, and the like, with benzene rings being preferred. Groups directly bonded to the anthracene ring may have additional substituents. Such substituents are not particularly restricted, other than a restriction against heterocyclic groups. It is sufficient for the number of carbon atoms of (a1) to be within the range of 6-130. Consequently, they may be the unfused cyclic hydrocarbon groups mentioned above, the fused cyclic hydrocarbon groups mentioned below or the acyclic hydrocarbon groups mentioned below (except for those comprising heterocyclic groups). Any of the substituents themselves may also have a substituent, or a plurality of substituents. This concept applies to all of (a1) to (a6) unless otherwise specified.

Further, favorable specific examples of C6-130 substituted or unsubstituted unfused cyclic hydrocarbon groups include phenyl, o-tolyl, m-tolyl, p-tolyl, 2-biphenylyl, 3-biphenylyl, 4-biphenylyl, 2,4-dimethylphenyl, 2,6-dimethylphenyl, 2,4,6-trimethylphenyl, 4-t-butylphenyl, 2,4-di-t-butylphenyl, 2,4,6-tri-t-butylphenyl, 4-cyclohexylphenyl, 3-(2-phenylethenyl)phenyl, 4-(2-phenylethenyl)phenyl, 3-(2,2-diphenylethenyl)phenyl, 4-(2,2-diphenylethenyl)phenyl, m-terphenyl-2'-yl, m-terphenyl-4'-yl, m-terphenyl-5'-yl, o-terphenyl-3'-yl, o-terphenyl-4'-yl, p-terphenyl-2'-yl, m-terphenyl-2-yl, m-terphenyl-3-yl, m-terphenyl-4-yl, o-terphenyl-2-yl, o-terphenyl-3-yl, o-terphenyl-4-yl, p-terphenyl-2-yl, p-terphenyl-3-yl, p-terphenyl-4-yl, 5'-phenyl-m-terphenyl-2-yl, 5'-phenyl-m-terphenyl-3-yl, 5'-phenyl-m-terphenyl-4-yl, m-quaterphenyl, 3,5-di(1-naphthyl)-phenyl, 3,5-di(2-naphthyl)-phenyl and the like.

Set (a2) is the subset of set (a1) which has the heterocyclic groups mentioned below as substituents. The substituents must be heterocyclic groups, and they may also have heterocyclic groups, as well as unfused cyclic hydrocarbon groups, fused cyclic hydrocarbon groups and acyclic hydrocarbon groups, as substituents. However, similar to set (a1), groups directly bonded to the anthracene ring must be unfused cyclic hydrocarbon groups. Although any desired heterocyclic groups may be used as the heterocyclic groups, the eight rings represented by formulas HT-1 to HT-8 may be mentioned as preferred examples.

Further, favorable specific examples of heterocyclic groups include 4-methyl-1,2,4-triazol-3-yl, 4-phenyl-1,2,4-triazol-3-yl, 5-phenyl-1,2,4-oxadiazol-2-yl, 5-(4-biphenyl)-1,2,4-oxadiazol-2-yl, 3-methyl-benzimidazole-2-yl, 3-phenyl-benzimidazole-2-yl, 2-pyridyl, 3-pyridyl, 4-pyridyl, 2-quinolyl, 3-quinolyl, 4-quinolyl, 5-quinolyl, 6-quinolyl, 7-quinolyl, 8-quinolyl, 2-quinoxalyl, 5-quinoxalyl, 6-quinoxalyl, 1-carbazolyl, 2-carbazolyl, 3-carbazolyl, 4-carbazolyl, 9-carbazolyl, 1-dibenzothienyl, 2-dibenzothienyl, 3-dibenzothienyl, 4-dibenzothienyl and the like.

Set (a3) comprises a C10-130 substituted or unsubstituted fused cyclic hydrocarbon group. Any desired fused cyclic hydrocarbon rings may be used as the fused cyclic hydrocarbon groups, but there may be mentioned as preferred groups substituted or unsubstituted naphthalene rings, anthracene rings, phenanthrene rings, pyrene rings, fluorene rings. These groups may also be used as substituents on the groups directly bonded to the anthracene ring. As other substituents there may be mentioned unfused cyclic hydrocarbon groups (with the exception of those containing heterocyclic groups).

Further, favorable specific examples of C10-130 substituted or unsubstituted fused cyclic hydrocarbon groups include 1-naphthyl, 2-naphthyl, 1-anthryl, 2-anthryl, 9-anthryl, 1-phenanthryl, 2-phenanthryl, 3-phenanthryl, 4-phenanthryl, 9-phenanthryl, 1-pyrenyl, 2-pyrenyl, 4-pyrenyl, 2-fluorenyl, 4-methyl-1-naphthyl, 4-t-butyl-1-naphthyl, 6-methyl-2-naphthyl, 6-t-butyl-2-naphthyl, 4-methyl-1-anthryl, 4-t-butyl-1-anthryl, 10-methyl-9-anthryl, 10-t-butyl-9-anthryl, 9,9-dimethyl-2-fluorenyl, 4-phenyl-1-naphthyl, 6-phenyl-2-naphthyl, 6-(2-naphthyl)-2-naphthyl, 6-(1-naphthyl)-2-naphthyl, 4-(2-naphthyl)-1-naphthyl, 4-(1-naphthyl)-1-naphthyl, 9,9-diphenyl-2-fluorenyl and the like.
The unfused cyclic hydrocarbon groups for substituents are preferably the groups described in (a1).

Groups of set (a4) which are directly bonded to the anthracene ring are the same as for set (a3), and they may have as substituents heterocyclic groups, unfused cyclic hydrocarbon groups, fused cyclic hydrocarbon groups and acyclic hydrocarbon groups. Favorable specific examples of heterocyclic groups, unfused cyclic hydrocarbon groups and fused cyclic hydrocarbon groups are listed in (a1) to (a3), and favorable specific examples of acyclic hydrocarbon groups are listed below.

Set (a5) comprises a C1-130 substituted or unsubstituted heterocyclic group wherein the atom directly bonded to the anthracene ring is an atom other than nitrogen. Groups directly bonded to the anthracene ring are not particularly restricted as heterocyclic groups except for the restrictions mentioned above, but the rings listed in (a2) are preferred. In addition, they may have as substituents, unfused cyclic hydrocarbon groups, acyclic hydrocarbon groups and heterocyclic groups. The groups listed in (a1) to (a3) are favorably illustrated for specific examples of these groups.

Set (a6) comprises a C1-50 acyclic hydrocarbon group. "Acyclic" means that the atoms directly bonded to the anthracene ring are not atoms forming a cyclic group, although a cyclic group may be present along the chain. Therefore, this includes not only alkyl and alkylene but also aralkyl groups, and cycloalkyl rings may also be present. Any desired methylene may also be replaced with - O-. Any desired methylene other than the 1-position methylene may also be replaced with phenylene or cycloalkylene. Also included are groups containing double bonds, such as phenylethenyl or diphenylethenyl. As acyclic hydrocarbon groups there are preferred C1-12 alkyl groups, with any desired methylene among the alkyls being optionally replaced with -O- and any desired methylene other than the 1-position methylene being optionally replaced with C6-12 arylene or C3-12 cycloalkylene, as well as phenylethenyl and diphenylethenyl.

Substituents for these groups may be selected from among unfused cyclic hydrocarbon groups, acyclic hydrocarbon groups and heterocyclic groups. The groups listed in (a1) to (a3) are favorably illustrated for specific examples of these groups.

Further, favorable specific examples of Cl-50 acyclic hydrocarbon groups include methyl, ethyl, n-propyl, i-propyl, n-butyl, t-butyl, 2-phenylethenyl, 2,2-diphenylethenyl, benzyl, diphenylmethyl, dimethylbenzyl, methoxy, ethoxy, phenoxy, o-tolyloxy, m-tolyloxy, p-tolyloxy, 1-naphthoxy, 2-naphthoxy, 2,4-dimethylphenoxy, 2,6-dimethylphenoxy, 2,4,6-trimethylphenoxy, 4-t-butylphenoxy, 2,4-di-t-butylphenoxy, 2,4,6-tri-t-butylphenoxy, 2-phenylethoxy, 2-(4-methylphenyl)ethoxy, cyclopropyl, cyclobutyl, cyclopentyl, cyclohexyl and the like.

The groups bonded directly to the anthracene ring are bonded with their substituents mentioned above by single bonds. These substituents and their substituents are also linked by single bonds. The groups A's in formula (F11) are formed by linkage of unfused cyclic hydrocarbon groups, acyclic hydrocarbon groups and heterocyclic groups by single bonds (horizontal or vertical in the formulas) under the specific restrictions stated above, and 1-10 groups A may be present. When a plurality of groups A's are present, they may be either the same or different. An anthracene ring has up to ten substitutable positions, and there is no restriction on the positions of the substituents.

The following are specific examples of anthracene derivatives to be used for the invention.

(1) t=1, (a3)

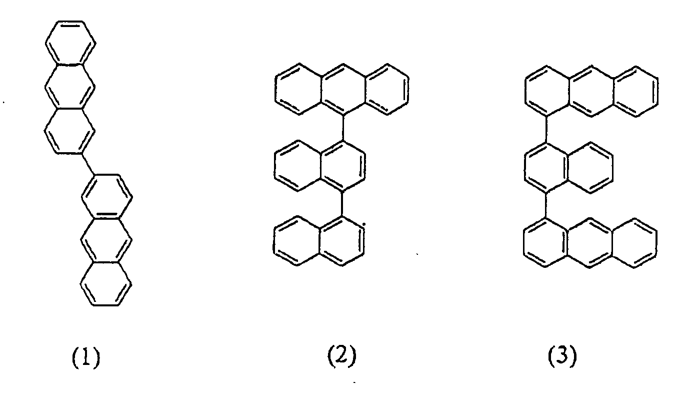

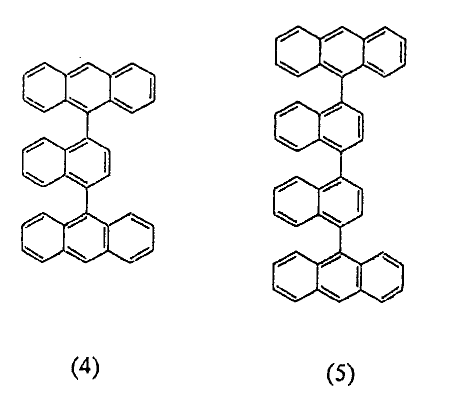

(2) t=2, (a1)

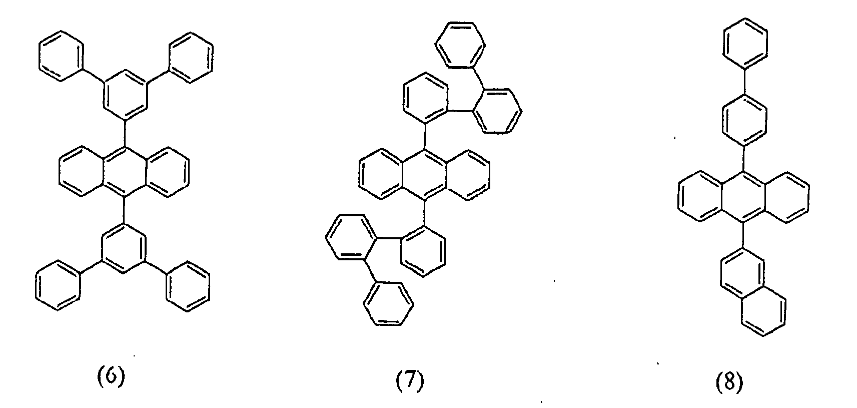

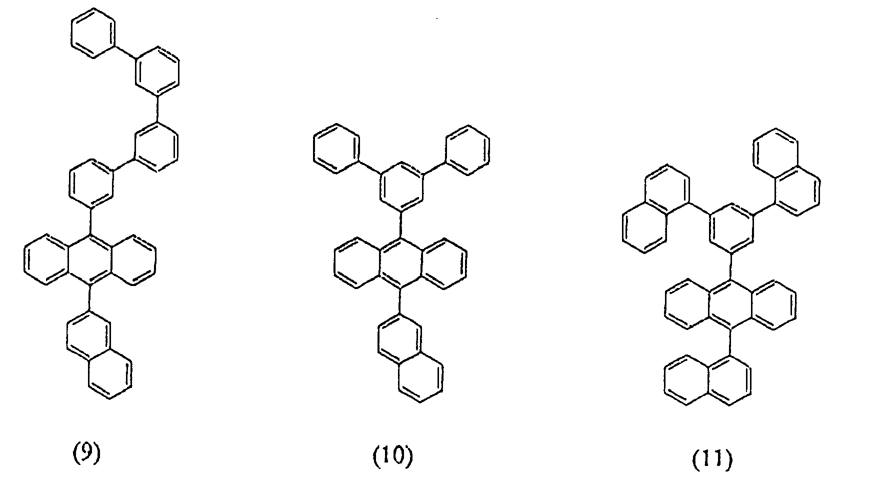

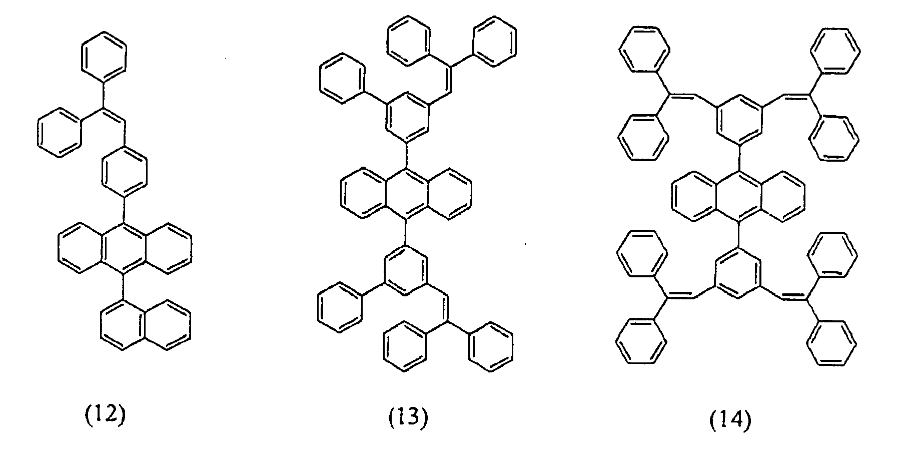

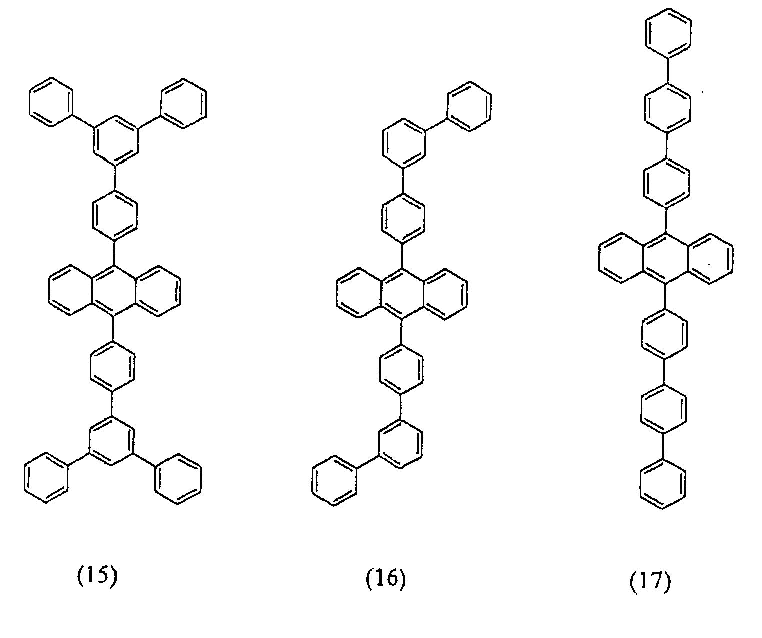

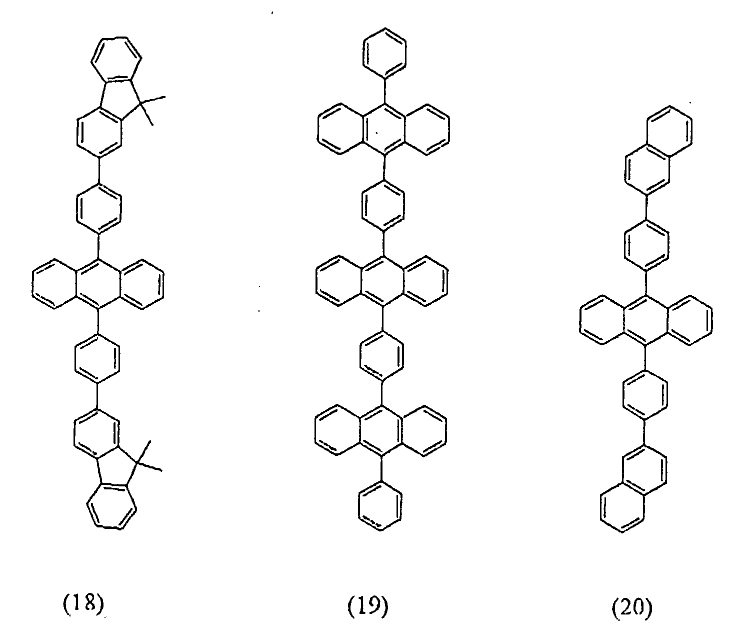

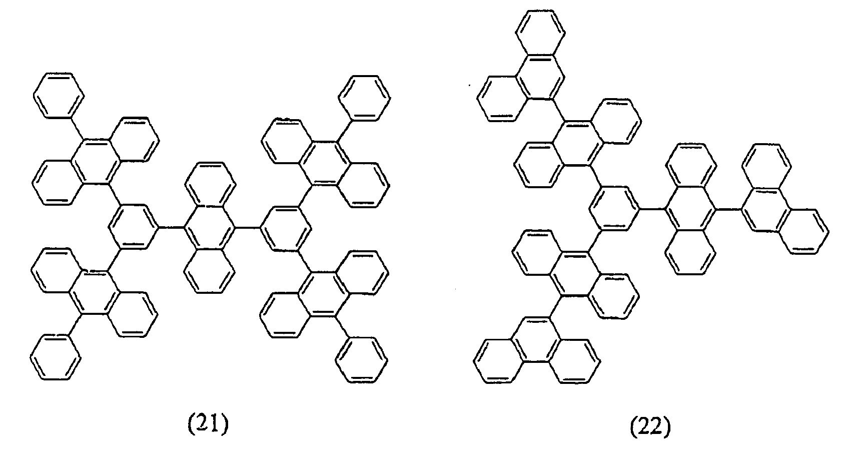

(3) t=2, (a3)

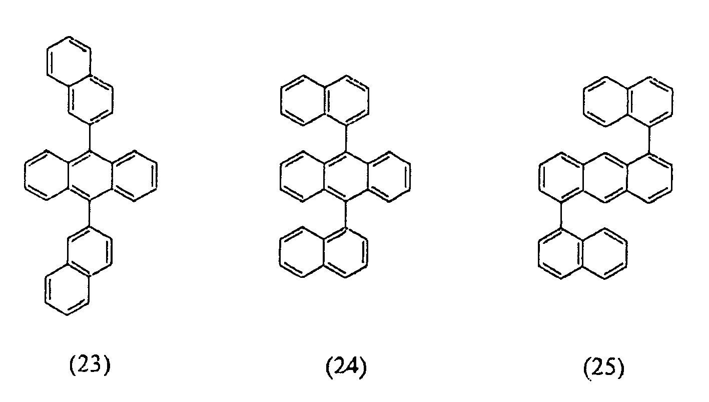

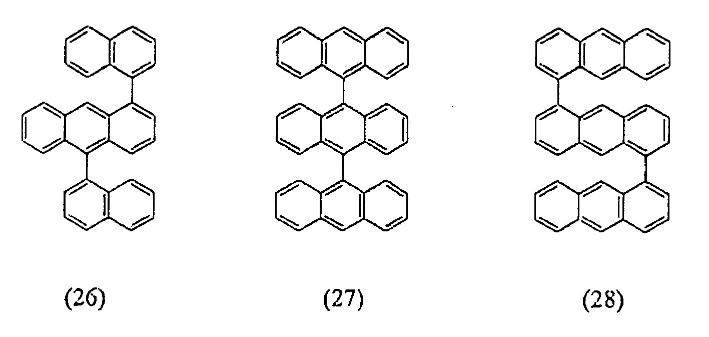

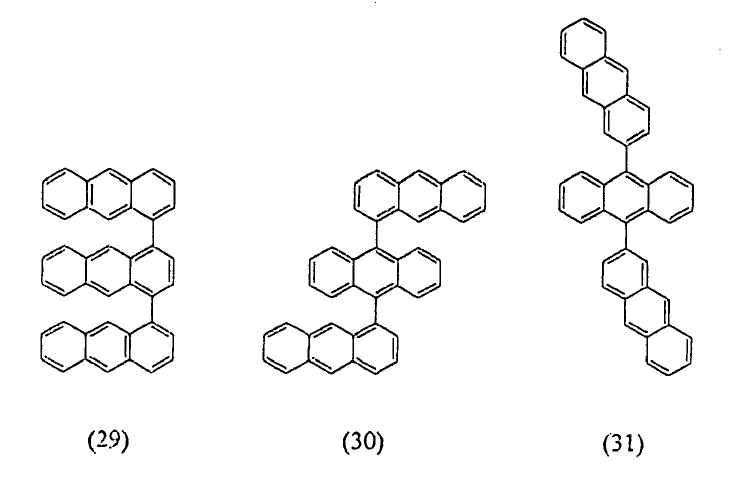

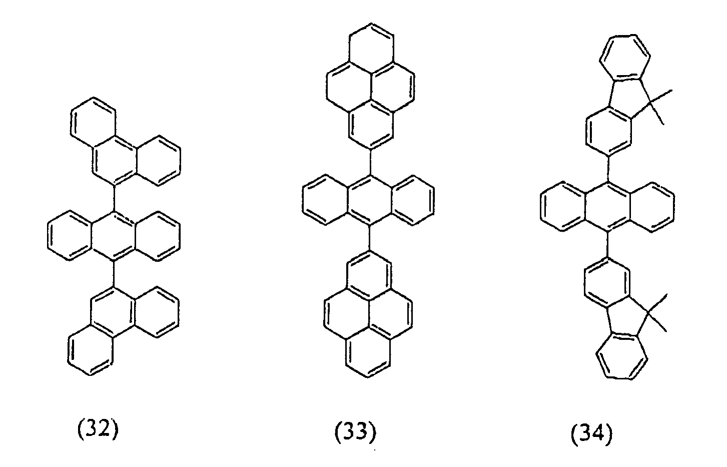

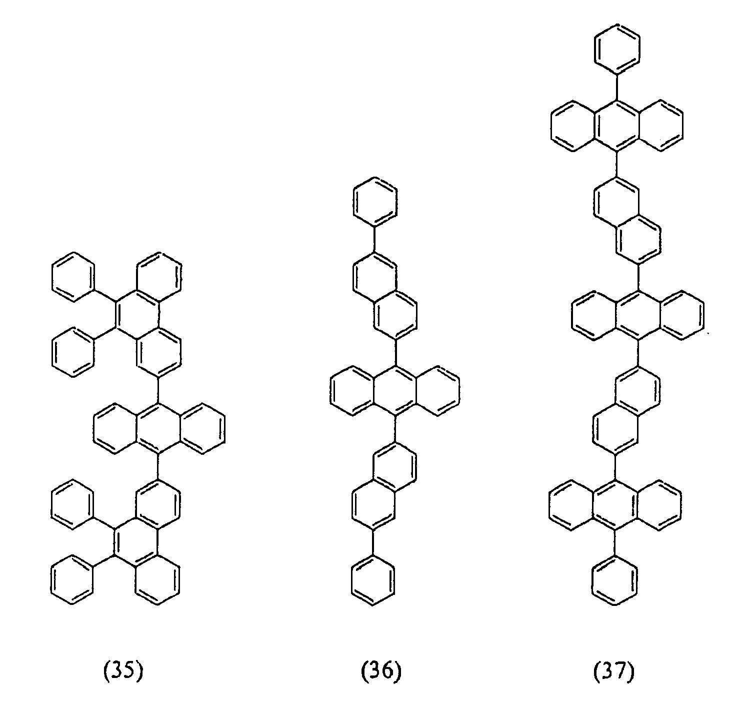

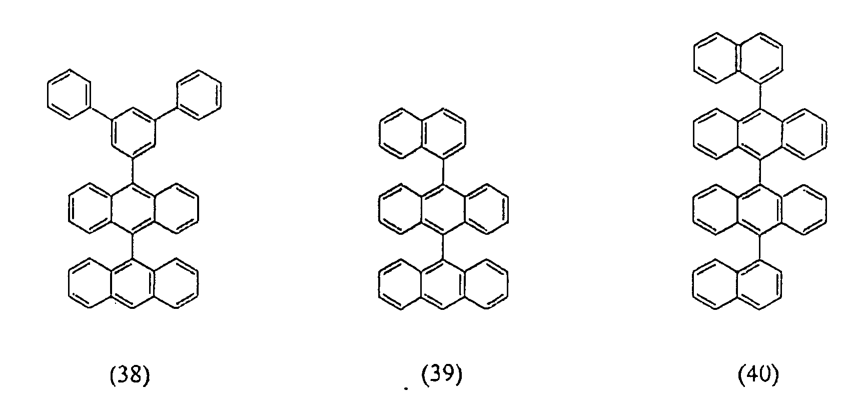

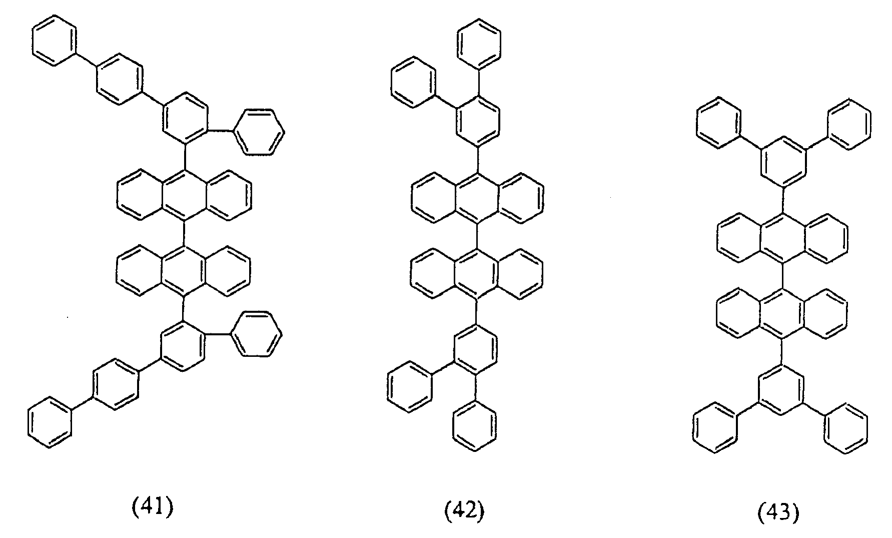

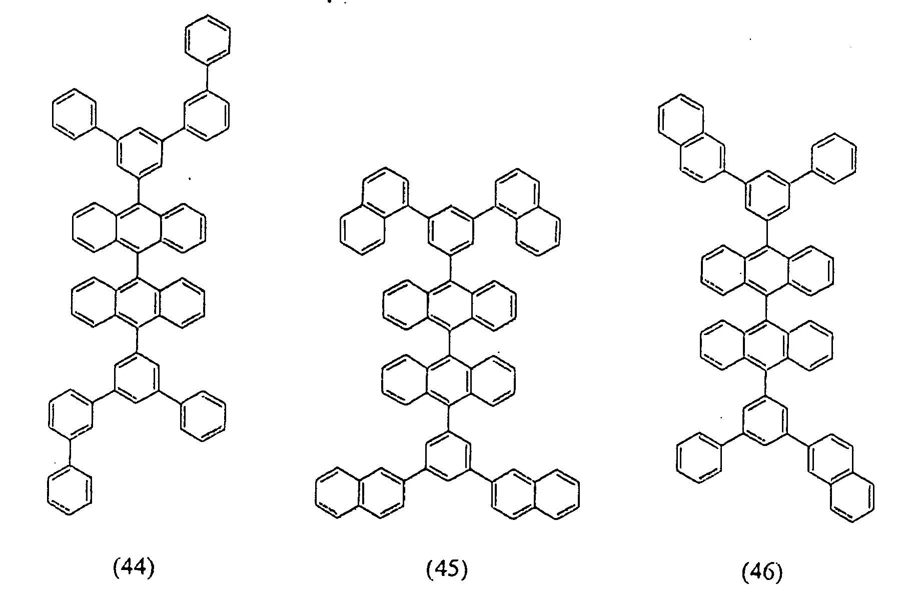

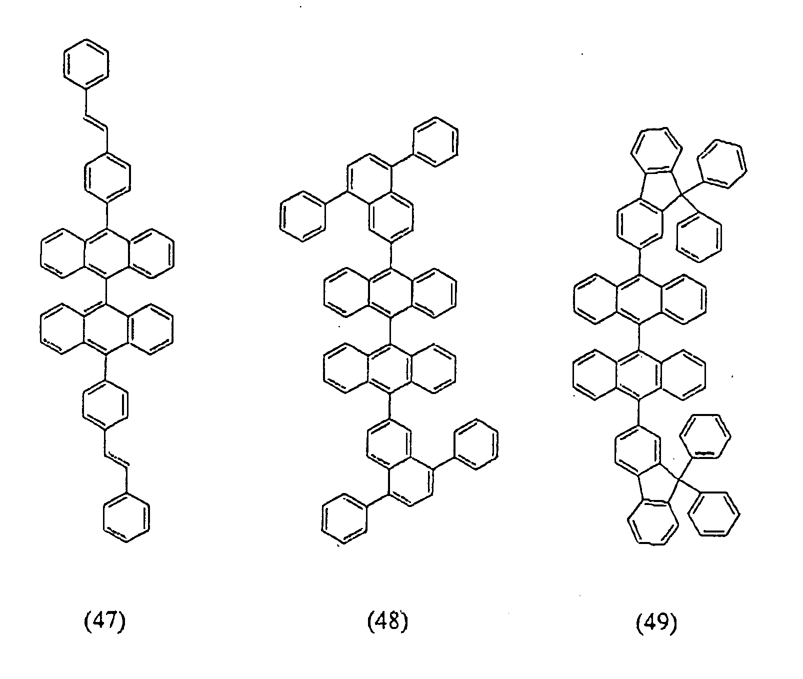

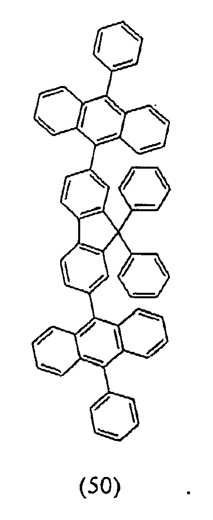

(4) t=2, (a4)

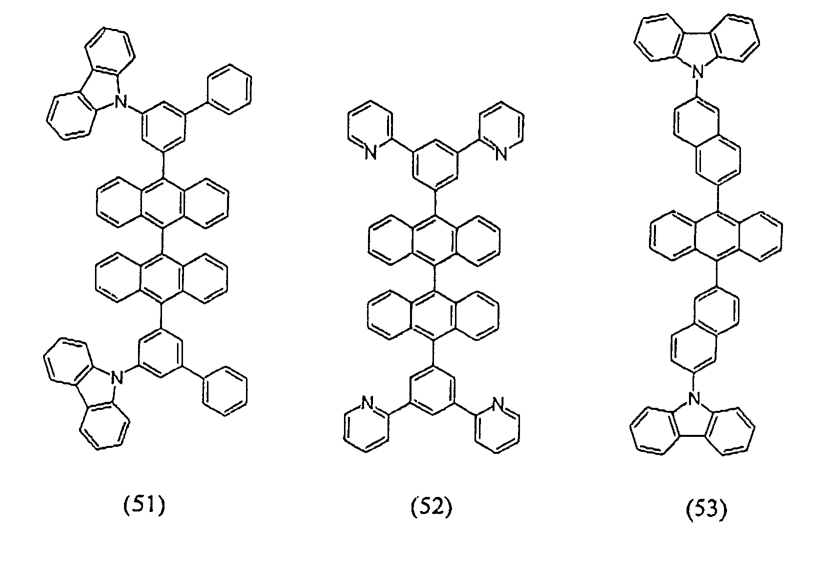

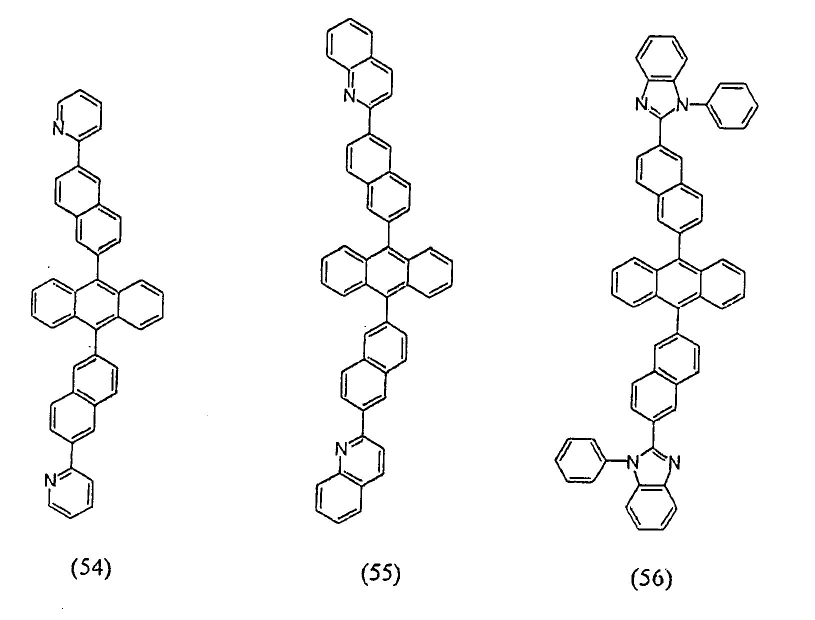

(5) t=2, (a5)

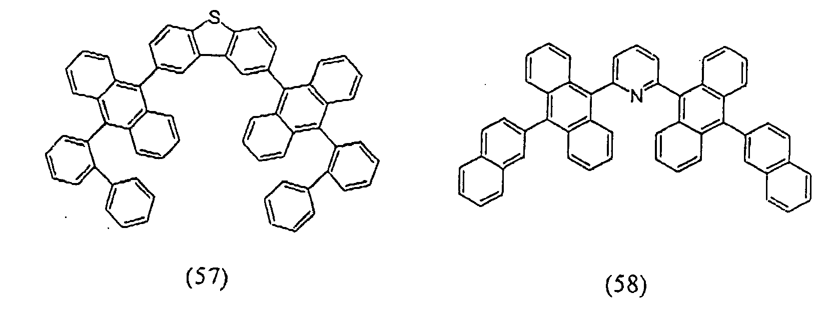

(6) t=2, (a6)

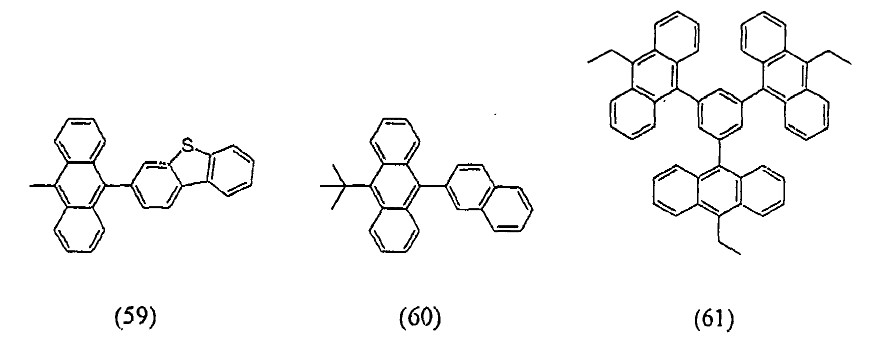

(7) t=3, (a1)

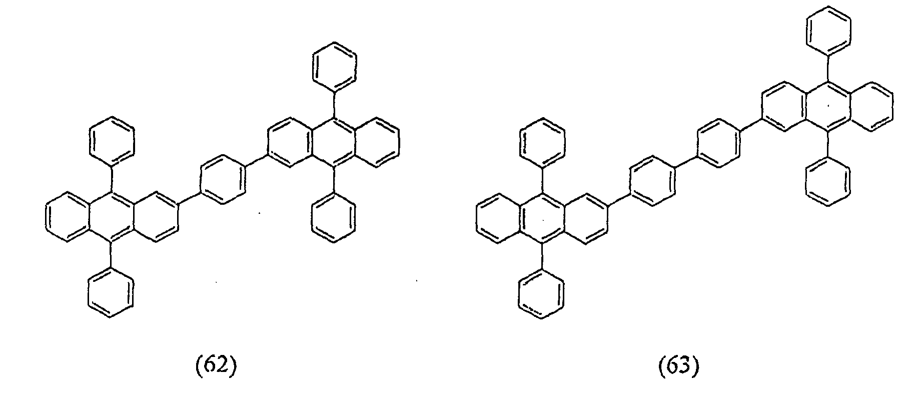

(8) t=3, (a3)

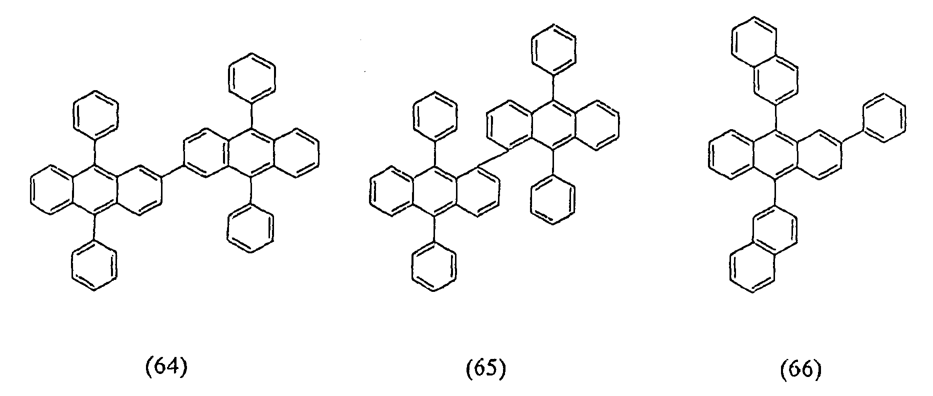

(9) t=3, (a6)

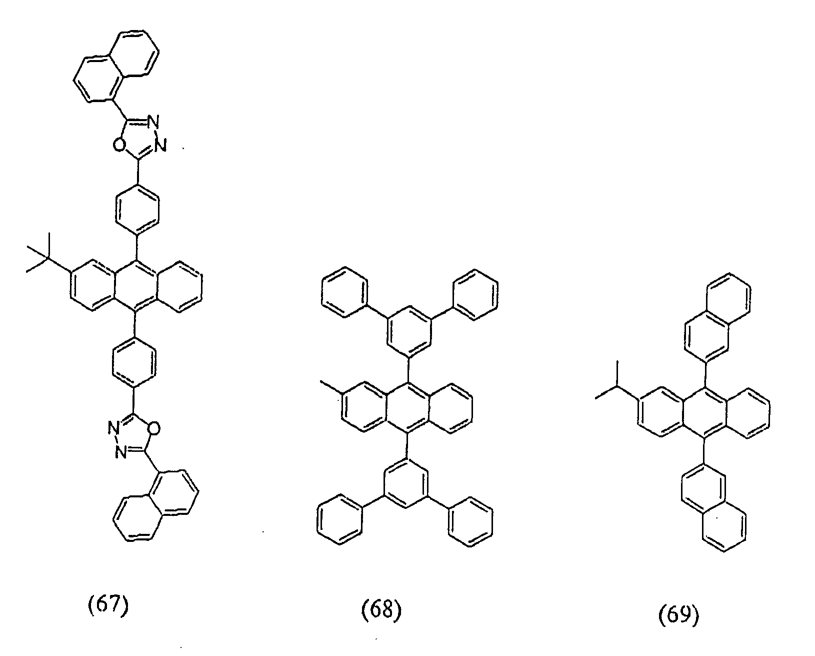

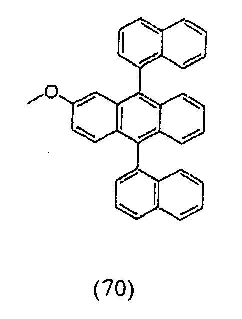

(10) t=4, (a1)

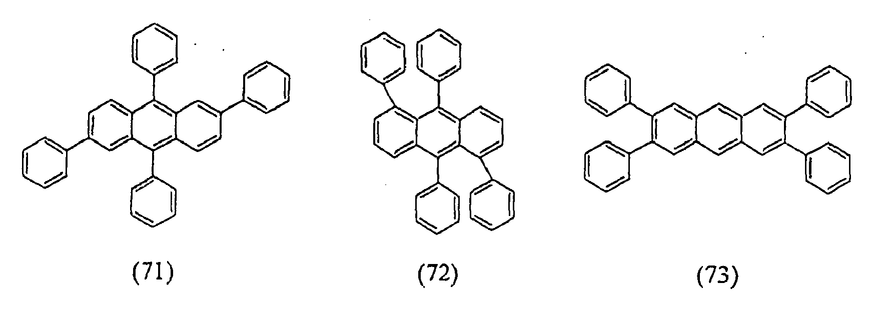

(11) t=4, (a3)

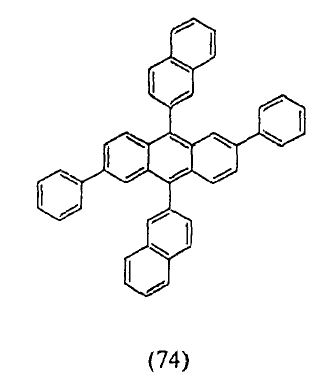

(12) t=8, (a1)

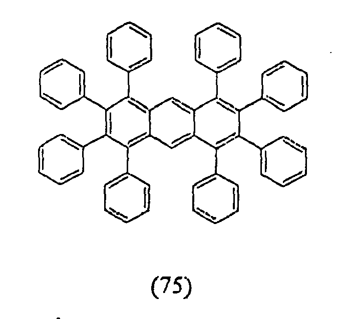

(13) t=10, (a1) 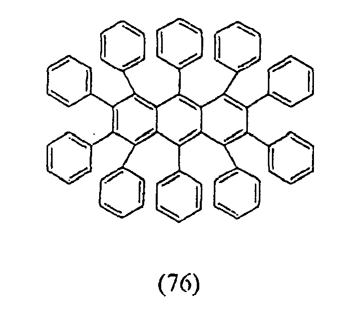 Favored are compounds (3), (6), (8), (10), (12), (16), (20), (23), (32), (36), (42), (43), (52), (53), (62), (64) and (71) among the exemplary compounds above.

The anthracene derivatives used for the invention may be synthesized utilizing known synthesis methods, such as the Suzuki coupling reaction. The Suzuki coupling reaction is a method for coupling an aromatic halide and aromatic boronic acid using a palladium catalyst in the presence of a base. A reaction example for the compound of formula (8) is shown below.

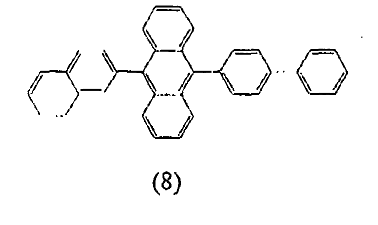

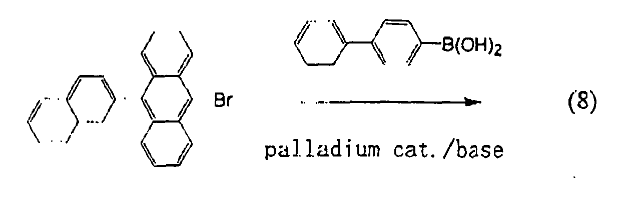

Specific examples of palladium catalysts to be used in the reaction include Pd(PPh₃)₄, PdCl₂(PPh₃)₂, Pd(OAc)₂, and the like. Specific examples of bases to be used in the reaction include sodium carbonate, potassium carbonate, cesium carbonate, sodium hydrogen carbonate, sodium hydroxide, potassium hydroxide, barium hydroxide, sodium ethoxide, sodium t-butoxide, sodium acetate, tripotassium phosphate, potassium fluoride, and the like. Specific examples of solvents to be used for the reaction include benzene, toluene, xylene, N,N-dimethylformamide, tetrahydrofuran, diethyl ether, t-butylmethyl ether, 1,4-dioxane, methanol, ethanol, isopropyl alcohol, and the like. These solvents may be appropriately selected depending on the structure of the aromatic halide and aromatic boronic acid used in the reaction. The solvents may be used alone or as mixed solvents.

The emitting layer used in the phosphorescent device of the invention comprises a host material and a dopant which emit phosphorescence. As host materials and dopants there may be mentioned the compounds described in Chemical Industry June 2004 on page 13, and the compounds referred to in the document as reference literatures.

The hole injection material and hole transport material used in the phosphorescent device of the invention may be selected from among compounds commonly used in the prior art as hole transport materials for photoconductive materials, p-type semiconductor materials or from among publicly known compounds used in hole injection layers and hole transport layers for organic electroluminescent devices. Specific examples include carbazole derivatives (N-phenylcarbazole, polyvinylcarbazole, etc.), triarylamine derivatives (polymers having aromatic tertiary amines on the main chain or a side chain, 1,1-bis(4-di-p-tolylaminophenyl)cyclohexane, N,N'-diphenyl-N,N'-di(3-methylphenyl)-4,4'-diaminobiphenyl, N,N'-diphenyl-N,N'-dinaphthyl-4,4'-diaminobiphenyl (hereinafter abbreviated as NPD), 4,4'.4"-tris{N-(3-methylphenyl)-N-phenylamino}triphenylamine, starburst amine derivatives, etc.), stilbene derivatives, phthalocyanine derivatives (non-metallic, copper phthalocyanine, etc.), polysilanes, and the like.

The electron transport material and electron injection material used in the phosphorescent device of the invention may also be selected as desired from among compounds commonly used in the prior art as electron transfer compounds for photoconductive materials, or from among publicly known compounds used in electron injection layers and electron transport layers of organic electroluminescent devices.

Specific examples of such electron transfer compounds include pyridine derivatives, phenanthroline derivatives, diphenylquinone derivatives, perylene derivatives, oxadiazole derivatives, thiophene derivatives, triazole derivatives, thiadiazole derivatives, metal complexs of oxine derivatives, quinolinol-based metal complexes, quinoxaline derivatives, quinoxaline derivative polymers, benzazole compounds, gallium complexes, pyrazole derivatives, perfluorinated phenylene derivatives, triazine derivatives, pyrazine derivatives, benzoquinoline derivatives, imidazopyridine derivatives, borane derivatives, and the like.

Preferred among these are pyridine derivatives (for example, 2,5-bis(6'-(2',2"-bipyridyl))-1,1-dimethyl-3,4-diphenylsilole (hereinafter abbreviated as PyPySPyPy), 9,10-di(2',2"-bipyridyl)anthracene, 2,5-di(2',2"-bipyridyl)thiophene, 2,5-di(3',2"-bipyridyl)thiophene, 6'6"-di(2-pyridyl)2,2':4',3":2",2'"-quaterpyridine, etc.), phenanthroline derivatives (for example, 4,7-diphenyl-1,10-phenanthroline, 2,9-dimethyl-4,7-diphenyl-1,10-phenanthroline, 9,10-di(1,10-phenanthroline-2-yl)anthracene, 2,6-di(1,10-phenanthroline-5-yl)pyridine, 1,3,5-tri(1,10-phenanthroline-5-yl)benzene, 9,9'-difluoro-bis(1,10-phenanthroline-.5-yl), etc.), and quinolinol-based metal complexes (for example, tris(3-hydroxyquinoline)aluminum. (hereinafter abbreviated as Alq3), bis(10-hydroxybenzo[h]quinoline)beryllium, tris(4-methyl-8-hydroxyquinoline) aluminum, bis(2-methyl-8-hydroxyquinoline)-(4-phenylphenol)aluminum, etc.).

In particular, low voltage and high efficiency can be achieved by using pyridine derivatives and phenanthroline derivatives in the electron transport layer or electron injection layer.

Each of the layers composing the phosphorescent device of the invention may be formed by producing a thin-film thereof by a publicly known process such as vapor deposition, printing, spin coating, casting, etc. of the material used to form each layer. The film thickness of each layer formed in this manner is not particularly restricted and may be appropriately determined depending on the nature of the material, but it will normally be in the range of 2-5000 nm. When vapor deposition is used to form a thin film, the vapor deposition conditions will differ depending on the type of materials, and on the crystal structure and association structure intended for the film. Generally, however, the conditions will preferably be appropriately set in ranges with a boat heating temperature of 50-400°C, a vacuum degree of 10⁻⁶ to 10⁻³ Pa, a vapor deposition rate of 0.01-50 nm/sec, a substrate temperature of -150 to +300°C and a film thickness of 5 nm to 5 *µ*m.

A method of fabricating a phosphorescent device comprising an anode/hole injection layer/ hole transport layer/emitting layer comprising a host material and dopant/hole blocking layer/electron transport layer/cathode will now be explained as an example of a method for fabricating a phosphorescent device using a hole blocking material according to the invention. After producing an anode by forming a thin-film of an anode material on a suitable substrate by vapor deposition, etc., thin-films of a hole injection layer and hole transport layer are formed on the anode. An emitting layer is produced thereover by forming a thin-film by co-vapor deposition of a luminescent host material and dopant, a hole blocking layer and electron transport layer are formed on the emitting layer, and then a cathode is produced by forming a thin-film composed of a cathode substance by vapor deposition, to obtain the intended phosphorescent device. The order of fabrication of the layers may also be reversed for fabrication of the phosphorescent device described above, i.e., they may be in the following order: cathode, electron transport layer, hole blocking layer, emitting layer, hole transport layer, hole injection layer, anode.

When a direct current voltage is applied to the phosphorescent device obtained in this manner, it may be an application sufficient to produce polarity of + at the anode and - at the cathode, and application of a voltage of about 2-40 V will produce visible luminescence from a transparent or semi-transparent electrode side (either the anode or cathode, or both). The phosphorescent device also emits light upon application of an alternating current voltage. The waveform of the applied alternating current may be any desired waveform.

### [Example 1]

ITO was vapor deposited on a glass substrate to a thickness of 150 nm to obtain a transparent support substrate. The transparent support substrate was affixed to the substrate holder of a commercially available vapor deposition apparatus, and there were mounted a molybdenum vapor deposition boat containing copper phthalocyanine (hereinafter referred to by the symbol CuPc), a molybdenum vapor deposition boat containing NPD, a molybdenum vapor deposition boat containing tris[2-(2-pyridinyl)phenyl-C,N]-iridium (hereinafter referred to by the symbol Ir(ppy)3), a molybdenum vapor deposition boat containing 4,4'-bis(carbazol-9-yl)-biphenyl (hereinafter referred to by the symbol CBP), a molybdenum vapor deposition boat containing compound (8), a molybdenum vapor deposition boat containing Alq3, a molybdenum vapor deposition boat containing lithium fluoride, and a tungsten vapor deposition boat containing aluminum.

After reducing the pressure of a vacuum chamber to 1 × 10⁻³ Pa, the CuPc-containing vapor deposition boat was heated for vapor deposition to a film thickness of 20 nm to form a hole injection layer, and then the NPD-containing vapor deposition boat was heated for vapor deposition to a film thickness of 30 nm to form a hole transport layer. The Ir(ppy)3-containing boat and CBP-containing boat were then simultaneously heated for vapor deposition to a film thickness of 20 nm to form an emitting layer. Next, the compound (8) containing boat was heated for vapor deposition to a film thickness of 5 nm to obtain a hole blocking layer. The vapor deposition rate was adjusted so that the weight ratio of the Ir(ppy)3 and CBP was approximately 8:92. Finally, the Alq3-containing vapor deposition boat was heated for vapor deposition to a film thickness of 35 nm to form an electron transport layer.

The vapor deposition rate for each layer was 0.001-3.0 nm/sec. Next, the lithium fluoride-containing vapor deposition boat was heated for vapor deposition at a vapor deposition rate of 0.003-0.01 nm/sec to a film thickness of 0.5 nm, and then the aluminum-containing vapor deposition boat was heated for vapor deposition at a vapor deposition rate of 0.1-1 nm/sec to a film thickness of 100 nm, to obtain a phosphorescent device.
When a direct current voltage of about 8.3 V was applied using an ITO electrode as the anode and a lithium fluoride/aluminum electrode as the cathode, a current of approximately 10.0 mA/cm² flowed and green luminescence was obtained having a brightness of about 3700 cd/m², a luminous efficiency of about 14.0 Lm/W and a spectrum with a peak wavelength of 510 nm. When a 10 mA/cm² direct current was applied for continuous operation, the initial brightness was approximately 3700 cd/m² and the brightness half time was about 300 hours.

### [Comparative Example 1] A phosphorescent device was obtained in exactly the same manner as Example 1, except that bis-(2-methyl-8-quinolinolato)-4-(phenyl-phenolato)-aluminum (hereinafter referred to as BAlq) was used for the hole blocking layer instead of the compound (8) in Example 1.

When a direct current voltage of about 8.7 V was applied using an ITO electrode as the anode and a lithium fluoride/aluminum electrode as the cathode, a current of approximately 10.0 mA/cm² flowed and green luminescence was obtained having a brightness of about 2900 cd/m², a luminous efficiency of about 10.5 Lm/W and a spectrum with a peak wavelength of 510 nm. When a 10 mA/cm² direct current was applied for continuous operation, the initial brightness was approximately 2900 cd/m² and the brightness half time was about 300 hours.

### [Comparative Example 2] A phosphorescent device was obtained in exactly the same manner as Example 1, except that 2,9-dimethyl-4,7-diphenyl-1,10-phenanthroline (hereinafter referred to as BCP) was used for the hole blocking layer instead of the compound (8) in Example 1.

When a direct current voltage of about 8.3 V was applied using an ITO electrode as the anode and a lithium fluoride/aluminum electrode as the cathode, a current of approximately 9.8 mA/cm² flowed and green luminescence was obtained having a brightness of about 3700 cd/m², a luminous efficiency of about 14.3 Lm/W and a spectrum with a peak wavelength of 510 nm. When a 9.8 mA/cm² direct current was applied for continuous operation, the initial brightness was approximately 3700 cd/m² and the brightness half time was about 50 hours.

### [Example 2]

A phosphorescent device was obtained in exactly the same manner as Example 1, except that 2,5-bis(6'-(2', 2"-bipyridyl))-1,1-dimethyl-3,4-diphenylsilol was used for the electron transport layer instead of the Alq3 in Example 1, and compound (3) was used for the hole blocking layer instead of the compound (8)in Example 1.
when a direct current voltage of about 7.3 v was applied using an ITO electrode as the anode and a lithium fluoride/aluminum electrode as the cathode, a current of approximately 10.0 mA/cm² flowed and green luminescence was obtained having a brightness of about 3700 cd/m², a luminous efficiency of about 15.9 Lm/W and a spectrum with a peak wavelength of 510 nm. When a 10 mA/cm² direct current was applied for continuous operation, the initial brightness was approximately 3700 cd/m² and the brightness half time was about 290 hours.

### [Example 3]

A phosphorescent device was obtained in exactly the same manner as Example 1, except that compound (24) was used for the hole blocking layer instead of the compound (8) in Example 1. When a direct current voltage of about 7.8 V was applied using an ITO electrode as the anode and a lithium fluoride/aluminum electrode as the cathode, a current of approximately 11.0 mA/cm² flowed and green luminescence was obtained having a brightness of about 3700 cd/m², a luminous efficiency of about 13.5 Lm/W and a spectrum with a peak wavelength of 510 nm. when a 11.0 mA/cm² direct current was applied for continuous operation, the initial brightness was approximately 3700 cd/m² and the brightness half time was about 350 hours.

### [Example 4]

A phosphorescent device was obtained in exactly the same manner as Example 1, except that compound (6) was used for the hole blocking layer instead of the compound (8) in Example 1.

When a direct current voltage of about 8.0 V was applied using an ITO electrode as the anode and a lithium fluoride/aluminum electrode as the cathode, a current of approximately 10.5 mA/cm² flowed and green luminescence was obtained having a brightness of about 3700 cd/m², a luminous efficiency of about 13.8 Lm/w and a spectrum with a peak wavelength of 510 nm. When a 10 mA/cm² direct current was applied for continuous operation, the initial brightness was approximately 3600 cd/m² and the brightness half time was about 310 hours.

### [Example 5]

A phosphorescent device was obtained in exactly the same manner as Example 1, except that compound (23) was used for the hole blocking layer instead of the compound (8) in Example 1.

when a direct current voltage of about 8.6 V was applied using an ITO electrode as the anode and a lithium fluoride/aluminum electrode as the cathode, a current of approximately 9.5 mA/cm² flowed and green luminescence was obtained having a brightness of about 3700 cd/m², a luminous efficiency of about 14.2 Lm/W and a spectrum with a peak wavelength of 510 nm. When a 10 mA/cm² direct current was applied for continuous operation, the initial brightness was approximately 3800 cd/m² and the brightness half time was about 310 hours.

### [Example 6]

A phosphorescent device was obtained in exactly the same manner as Example 1, except that compound (16) was used for the hole blocking layer instead of the compound (8) in Example 1.

When a direct current voltage of about 8.3 V was applied using an ITO electrode as the anode and a lithium fluoride/aluminum electrode as the cathode, a current of approximately 10.0 mA/cm² flowed and green luminescence was obtained having a brightness of about 3700 cd/m², a luminous efficiency of about 14.0 Lm/W and a spectrum with a peak wavelength of 510 nm. When a 10 mA/cm² direct current was applied for continuous operation, the initial brightness was approximately 3700 cd/m² and the brightness half time was about 310 hours.

### [Example 7]

A phosphorescent device was obtained in exactly the same manner as Example 1, except that compound (42) was used for the hole blocking layer instead of the compound (8) in Example 1.

When a direct current voltage of about 7.8 V was applied using an ITO electrode as the anode and a lithium fluoride/aluminum electrode as the cathode, a current of approximately 11.0 mA/cm² flowed and green luminescence was obtained having a brightness of about 3700 cd/m², a luminous efficiency of about 13.5 Lm/W and a spectrum with a peak wavelength of 510 nm. When a 10.0 mA/cm² direct current was applied for continuous operation, the initial brightness was approximately 3600 cd/m² and the brightness half time was about 340 hours.

### [Example 8]

A phosphorescent device was obtained in exactly the same manner as Example 1, except that compound (52) was used for the hole blocking layer instead of the compound (8) in Example 1.

When a direct current voltage of about 8.0 V was applied using an ITO electrode as the anode and a lithium fluoride/aluminum electrode as the cathode, a current of approximately 10.0 mA/cm² flowed and green luminescence was obtained having a brightness of about 3700 cd/m², a luminous efficiency of about 14.5 Lm/W and a spectrum with a peak wavelength of 510 nm. When a 10 mA/cm² direct current was applied for continuous operation, the initial brightness was approximately 3700 cd/m² and the brightness half time was about 320 hours.

### [Example 9]

ITO was vapor deposited on a glass substrate to a thickness of 150 nm to obtain a transparent support substrate. The transparent support substrate was affixed to the substrate holder of a commercially available vapor deposition apparatus, and there were mounted a molybdenum vapor deposition boat containing CuPc, a molybdenum vapor deposition boat containing NPD, a molybdenum vapor deposition boat containing bis[(4,6-difluorophenyl)-pyridinate-N,C2'] pinacolateiridium (hereinafter referred to by the symbol of Flrpic), a molybdenum vapor deposition boat containing CBP, a molybdenum vapor deposition boat containing compound (62), a molybdenum vapor deposition boat containing Alq3, a molybdenum vapor deposition boat containing lithium fluoride, and a tungsten vapor deposition boat containing aluminum.

After reducing the pressure of a vacuum chamber to 1 × 10⁻³ Pa, the CuPc-containing vapor deposition boat was heated for vapor deposition to a film thickness of 20 nm to form a hole injection layer, and then the NPD-containing vapor deposition boat was heated for vapor deposition to a film thickness of 30 nm to form a hole transport layer. The Flrpic-containing boat and CBP-containing boat were then simultaneously heated for vapor deposition to a film thickness of 20 nm to form an emitting layer. Next, the compound (62) containing vapor deposition boat was heated for vapor deposition to a film thickness of 5 nm to obtain a hole blocking layer. The vapor deposition rate was adjusted so that the weight ratio of the Flrpic and CBP was approximately 8:92. Finally, the Alq3-containing vapor deposition boat was heated for vapor deposition to a film thickness of 35 nm to form an electron transport layer.
The vapor deposition rate for each layer was 0.01-3.0 nm/sec. Next, the lithium fluoride-containing vapor deposition boat was heated for vapor deposition at a vapor deposition rate of 0.003-0.01 nm/sec to a film thickness of 0.5 nm, and then the aluminum-containing vapor deposition boat was heated for vapor deposition at a vapor deposition rate of 0.1-1 nm/sec to a film thickness of 100 nm, to obtain a phosphorescent device.
When a direct current voltage of about 7.49 V was applied using an ITO electrode as the anode and a lithium fluoride/aluminum electrode as the cathode, a current of approximately 10.0 mA/cm² flowed and blue luminescence was obtained having a brightness of about 816 cd/m², a luminous efficiency of about 3.42 Lm/W. When a 10.0 mA/cm² direct current was applied for continuous operation, the initial brightness was approximately 816 cd/m² and the brightness half time was about 300 hours.

### [Comparative Example 3]

A phosphorescent device was obtained in exactly the same manner as Example 9, except that a triazole derivative having the structure shown below was used instead of the compound (62) for the hole blocking layer.
When a direct current voltage of about 7.73 V was applied using an ITO electrode as the anode and a lithium fluoride/aluminum electrode as the cathode, a current of approximately 10.0 mA/cm² flowed and blue luminescence was obtained having a brightness of about 758 cd/m², a luminous efficiency of about 3.08 Lm/W. When a 10 mA/cm² direct current was applied for continuous operation, the initial brightness was approximately 758 cd/m² and the brightness half time was about 100 hours.

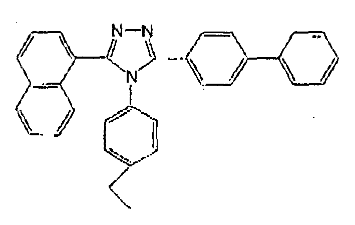

### [Example 10]

A phosphorescent device was obtained in exactly the same manner as Example 9, except that compound (71) was used instead of the compound (62) for the hole blocking layer.

When a direct current voltage of about 7.55 V was applied using an ITO electrode as the anode and a lithium fluoride/aluminum electrode as the cathode, a current of approximately 10.0 mA/cm² flowed and blue luminescence was obtained having a brightness of about 830 cd/m² and a luminous efficiency of about 3.45 Lm/W . When a 10 mA/cm² direct current was applied for continuous operation, the initial brightness was approximately 830 cd/m² and the brightness half time was about 320 hours.

### [Example 11]

A phosphorescent device was obtained in exactly the same manner as Example 9, except that compound (12) was used instead of the compound (62) for the hole blocking layer.

When a direct current voltage of about 7.60 V was applied using an ITO electrode as the anode and a lithium fluoride/aluminum electrode as the cathode, a current of approximately 10.0 mA/cm² flowed and blue luminescence was obtained having a brightness of about 820 cd/m², a luminous efficiency of about 3.39 Lm/W. When a 10 mA/cm² direct current was applied for continuous operation, the initial brightness was approximately 820 cd/m² and the brightness half time was about 295 hours.

## Claims

1. A phosphorescent device comprising at least an emitting layer situated between a pair of electrodes and at least one positive hole blocking layer in direct contact with the emitting layer, wherein the phosphorescent device employs as the hole blocking layer, a compound which can be used as a blue luminescent host material.

2. A phosphorescent device according to claim 1, which comprises at least an electron transport layer, a positive hole blocking layer, an emitting layer, a positive hole transport layer and a positive hole injection layer, situated between a pair of electrodes.

3. A phosphorescent device according to claims 1 or 2, wherein the compound which can be used as a blue luminescent host material is at least one type of compounds represented by formula (F11) and having a molecular weight of 340 or greater.
Ant(A)ₜ (F11)
wherein Ant is an anthracene ring of valence t, t is an integer of 1 to 10, and each A is independently any one of sets (a1) to (a6) below, with the proviso that (a6) is a group which coexists with at least one group from among sets (a1) to (a5):
(a1): a monovalent C6-130 substituted or unsubstituted unfused cyclic hydrocarbon group wherein the substituents include no heterocyclic groups;
(a2): a monovalent C6-130 substituted unfused cyclic hydrocarbon group wherein the substituents include heterocyclic groups;
(a3): a monovalent C10-130 substituted or unsubstituted fused cyclic hydrocarbon group wherein the substituents include no heterocyclic groups;
(a4): a monovalent C10-130 substituted fused cyclic hydrocarbon group wherein the substituents include heterocyclic groups;
(a5): a monovalent C1-130 substituted or unsubstituted heterocyclic group wherein the atom directly bonded to the anthracene ring is an atom other than nitrogen;
(a6): a monovalent C1-50 acyclic hydrocarbon group.

4. A phosphorescent device according to claim 3, wherein at least one A in formula (F11) is a group represented by (al).

5. A phosphorescent device according to claim 3, wherein at least one A in formula (F11) is a group represented by (a2).

6. A phosphorescent device according to claim 3, wherein at least one A in formula (F11) is a group represented by (a3).

7. A phosphorescent device according to claim 3, wherein at least one A in formula (F11) is a group represented by (a4).

8. A phosphorescent device according to claim 3, wherein at least one A in formula (F11) is a group represented by (a5).

9. A phosphorescent device according to claim 3, wherein at least one A in formula (F11) is a group represented by (a6), and at least one A is a group represented by any one of (a1) to (a5).

10. A phosphorescent device according to claim 4, wherein (a1) is a group comprising 1-10 substituted or unsubstituted benzene rings.

11. A phosphorescent device according to claim 6, wherein (a3) is a group comprising 1-10 rings selected from among substituted or unsubstituted naphthalene rings, anthracene rings, phenanthrene rings, pyrene rings, and fluorene rings.

12. A phosphorescent device according to claim 8, wherein (a5) is a group comprising 1-10 rings selected from among the following substituted or unsubstituted heterocycles: 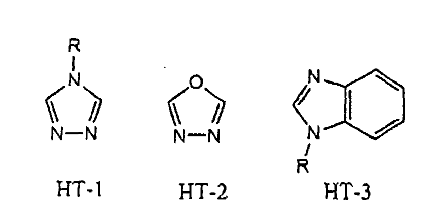 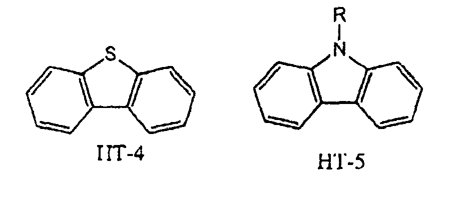 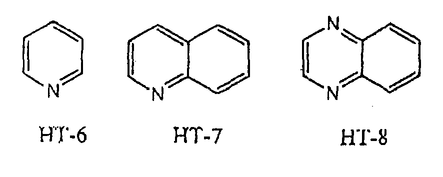
wherein R represents hydrogen, C1-6 alkyl or C6-18 aryl.

13. A phosphorescent device according to any one of claims 10 to 12, wherein the substituents of A are groups comprising 1-10 rings or groups selected from among substituted or unsubstituted benzene rings, naphthalene rings, anthracene rings, phenanthrene rings, pyrene rings, fluorene rings, and the following rings: 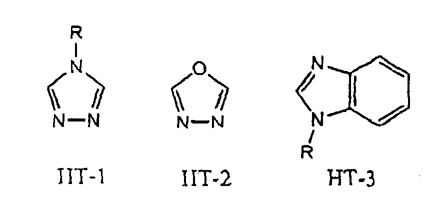 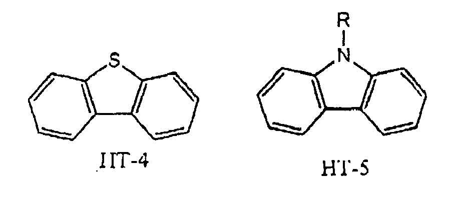 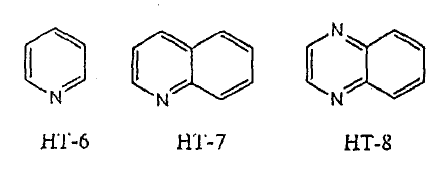
wherein R represents hydrogen, C1-6 alkyl or C6-18 aryl, as well as from phenylethenyl and diphenylethenyl.

14. A phosphorescent device according to any one of claims 10 to 12, wherein the substituents of the substituents of A are C1-12 alkyl, with any desired methylene among the alkyls being optionally replaced with -O- and any desired methylene other than the 1-position methylene being optionally replaced with C6-12 arylene or C3-12 cycloalkylene.

15. A phosphorescent device according to claim 13, wherein the substituents of the substituents of A are C1-12 alkyl, phenylethenyl or diphenylethenyl, with any desired methylene among the alkyls being optionally replaced with -O- and any desired methylene other than the 1-position methylene being optionally replaced with C6-12 arylene or C3-12 cycloalkylene.

16. A phosphorescent device according to any one of claims 3 to 15, wherein A consists of at least two different groups selected from among (a1), (a2), (a3), (a4), (a5) and (a6).

17. A phosphorescent device according to claim 4 or 10, wherein A consists of (a1) alone.

18. A phosphorescent device according to claim 6 or 11, wherein A consists of (a3) alone.

19. A phosphorescent device according to claim 4, 6, 10, 11 or 16, wherein A consists of (al) and (a3) alone.

20. A phosphorescent device according to any one of claims 3 to 19, wherein two A's are bonded at the 9- and 10-positions of Ant.

21. A phosphorescent device according to any one of claims 3 to 20, wherein t=2.

22. A phosphorescent device according to any one of claims 3 to 20, wherein t=3.

23. A phosphorescent device according to any one of claims 3 to 20, wherein t=4-10.

24. A phosphorescent device according to claim 3, wherein, in formula (F11), t=1 and A is a substituted phenyl, with at least a hydrogen on the phenyl being optionally replaced with at least one member selected from the group consisting of phenyl, biphenyl, terphenyl, naphthyl, anthryl, phenanthryl, fluorenyl, pyrenyl, benzyl, pyridyl, carbazolyl, benzimidazolyl, quinolyl and quinoxalyl.

25. A phosphorescent device according to claim 3, wherein, in formula (F11), t=1 and A is naphthyl, anthryl, phenanthryl or a group, with at least a hydrogen on a group selected from these groups being optionally replaced with at least one member selected from the group consisting of methyl, ethyl, t-butyl, methoxy, ethoxy, phenyl, biphenyl, terphenyl, phenylethenyl, diphenylethenyl, naphthyl, anthryl, phenanthryl, fluorenyl, pyrenyl, benzyl, pyridyl, carbazolyl, benzimidazolyl, quinolyl and quinoxalyl.

26. A phosphorescent device according to claim 24 or 25, wherein the number of the substituents is one to three.

27. A phosphorescent device according to claim 3, wherein, in formula (F11), t=1 and A is a substituted phenyl, with four hydrogens on the phenyl being optionally replaced with at least one member selected from the group consisting of phenyl, biphenyl, terphenyl, naphthyl, anthryl, phenanthryl, fluorenyl, pyrenyl, benzyl, pyridyl, carbazolyl, benzimidazolyl, quinolyl and quinoxalyl.

28. A phosphorescent device according to claim 3, wherein, in formula (F11), t=1 and A is naphthyl, anthryl, phenanthryl or a group, with four hydrogens on a group selected from these groups being optionally replaced with at least one member selected from the group consisting of methyl, ethyl, t-butyl, methoxy, ethoxy, phenyl, biphenyl, terphenyl, phenylethenyl, diphenylethenyl, naphthyl, anthryl, phenanthryl, fluorenyl, pyrenyl, benzyl, pyridyl, carbazolyl, benzimidazolyl, quinolyl and quinoxalyl.

29. A phosphorescent device according to any one of claims 24 to 28, wherein A is bonded at the 9- or 10-positions of Ant.

30. A phosphorescent device according to claim 3, wherein, in formula (F11), t=2 and one of A's is a substituted phenyl, with at least a hydrogen on the phenyl being optionally replaced with at least one member selected from the group consisting of phenyl, biphenyl, terphenyl, phenylethenyl, diphenylethenyl, naphthyl, anthryl, phenanthryl, fluorenyl, pyrenyl, benzyl, pyridyl, carbazolyl, benzimidazolyl, quinolyl and quinoxalyl, and the other of A's is phenyl, naphthyl, anthryl, phenanthryl or a group, with at least a hydrogen on a group selected from these groups being optionally replaced with at least one member selected from the group consisting of methyl, ethyl, t-butyl, methoxy, ethoxy, phenyl, biphenyl, terphenyl, phenylethenyl, diphenylethenyl, naphthyl, anthryl, phenanthryl, fluorenyl, pyrenyl, benzyl, pyridyl, carbazolyl, benzimidazolyl, quinolyl and quinoxalyl.

31. A phosphorescent device according to claim 3, wherein, in formula (F11), t=2 and one of A's is naphthyl, anthryl, phenanthryl or a group, with at least a hydrogen on a group selected from these groups being optionally replaced with at least one member selected from the group consisting of methyl, ethyl, t-butyl, methoxy, ethoxy, phenyl, biphenyl, terphenyl, phenylethenyl, diphenylethenyl, naphthyl, anthryl, phenanthryl, fluorenyl, pyrenyl, benzyl, pyridyl, carbazolyl, benzimidazolyl, quinolyl and quinoxalyl, and the other of A's is phenyl, naphthyl, anthryl, phenanthryl or a group, with at least a hydrogen on a group selected from these groups being optionally replaced with at least one member selected from the group consisting of methyl, ethyl, t-butyl, methoxy, ethoxy, phenyl, biphenyl, terphenyl, phenylethenyl, diphenylethenyl, naphthyl, anthryl, phenanthryl, fluorenyl, pyrenyl, benzyl, pyridyl, carbazolyl, benzimidazolyl, quinolyl and quinoxalyl.

32. A phosphorescent device according to claim 30 or 31, wherein the number of the substituents is one to three.

33. A phosphorescent device according to claim 3, wherein, in formula (F11), t=2 and one of A's is a substituted phenyl, with four hydrogens on the phenyl being optionally replaced with at least one member selected from the group consisted of phenyl, biphenyl, terphenyl, naphthyl, anthryl, phenanthryl, fluorenyl, pyrenyl, benzyl, pyridyl, carbazolyl, benzimidazolyl, quinolyl and quinoxalyl, and the other of A's is phenyl, naphthyl, anthryl, phenanthryl or a group, with one to four hydrogens on a group selected from these groups being optionally replaced with at least one member selected from the group consisting of methyl, ethyl, t-butyl, methoxy, ethoxy, phenyl, biphenyl, terphenyl, phenylethenyl, diphenylethenyl, naphthyl, anthryl, phenanthryl, fluorenyl, pyrenyl, benzyl, pyridyl, carbazolyl, benzimidazolyl, quinolyl and quinoxalyl.

34. A phosphorescent device according to claim 3, wherein, in formula (F11), t=2 and one of A's is a group, with four hydrogens on a group selected from naphthyl, anthryl and phenanthryl being optionally replaced with at least one member selected from the group consisting of methyl, ethyl, t-butyl, methoxy, ethoxy, phenyl, biphenyl, terphenyl, phenylethenyl, diphenylethenyl, naphthyl, anthryl, phenanthryl, fluorenyl, pyrenyl, benzyl, pyridyl, carbazolyl, benzimidazolyl, quinolyl and quinoxalyl, and the other of A's is phenyl, naphthyl, anthryl, phenanthryl, pyridyl or a group, with one to four hydrogens on a group selected from these groups being optionally replaced with at least one member selected from the group consisting of methyl, ethyl, t-butyl, methoxy, ethoxy, phenyl, biphenyl, terphenyl, phenylethenyl, diphenylethenyl, naphthyl, anthryl, phenanthryl, fluorenyl, pyrenyl, benzyl, pyridyl, carbazolyl, benzimidazolyl, quinolyl and quinoxalyl.

35. A phosphorescent device according to any one of claims 30 to 34, wherein two A's are bonded at the 9- and 10-positions of Ant.

36. A phosphorescent device according to claim 3, wherein, in formula (F11), t=3 and one of A's is a substituted phenyl, with at least a hydrogen on the phenyl being optionally replaced with at least one member selected from the group consisting of phenyl, biphenyl, terphenyl, phenylethenyl, diphenylethenyl, naphthyl, anthryl, phenanthryl, fluorenyl, pyrenyl, benzyl, pyridyl, carbazolyl, benzimidazolyl, quinolyl and quinoxalyl, and the other two A's are independently phenyl, naphthyl, anthryl, phenanthryl or groups, with at least a hydrogen on a group selected from these groups being optionally replaced with at least one member selected from the group consisting of methyl, ethyl, t-butyl, methoxy, ethoxy, phenyl, biphenyl, terphenyl, phenylethenyl, diphenylethenyl, naphthyl, anthryl, phenanthryl, fluorenyl, pyrenyl, benzyl, pyridyl, carbazolyl, benzimidazolyl, quinolyl and quinoxalyl.

37. A phosphorescent device according to claim 3, wherein, in formula (F11), t=3 and one of A's is naphthyl, anthryl phenanthryl or a group, with at least a hydrogen on a group selected from these groups being optionally replaced with at least one member selected from the group consisting of methyl, ethyl, t-butyl, methoxy, ethoxy, phenyl, biphenyl, terphenyl, phenylethenyl, diphenylethenyl, naphthyl, anthryl, phenanthryl, fluorenyl, pyrenyl, benzyl, pyridyl, carbazolyl, benzimidazolyl, quinolyl and quinoxalyl, and the other two A's are independently phenyl, naphthyl, anthryl, phenanthryl or groups, with at least a hydrogen on a group selected from these groups being optionally replaced with at least one member selected from the group consisting of methyl, ethyl, t-butyl, methoxy, ethoxy, phenyl, biphenyl, terphenyl, phenylethenyl, diphenylethenyl, naphthyl, anthryl, phenanthryl, fluorenyl, pyrenyl, benzyl, pyridyl, carbazolyl, benzimidazolyl, quinolyl and quinoxalyl.

38. A phosphorescent device according to claim 36 or 37, wherein the number of the substituents is one to three.

39. A phosphorescent device according to claim 3, wherein, in formula (F11), t=3 and one of A's is a substituted phenyl, with four hydrogens on the phenyl being optionally replaced with at least one member selected from the group consisting of phenyl, biphenyl, terphenyl, naphthyl, anthryl, phenanthryl, fluorenyl, pyrenyl, benzyl, pyridyl, carbazolyl, benzimidazolyl, quinolyl and quinoxalyl, and the other two A's are independently phenyl, naphthyl, anthryl, phenanthryl or a group, with one to four hydrogens on a group selected from these groups being optionally replaced with at least one member selected from the group consisting of methyl, ethyl, t-butyl, methoxy, ethoxy, phenyl, biphenyl, terphenyl, phenylethenyl, diphenylethenyl, naphthyl, anthryl, phenanthryl, fluorenyl, pyrenyl, benzyl, pyridyl, carbazolyl, benzimidazolyl, quinolyl and quinoxalyl.

40. A phosphorescent device according to claim 3, wherein, in formula (F11), t=3 and one of A's is a group, with four hydrogens on a group selected from naphthyl, anthryl and phenanthryl being optionally replaced with at least one member selected from the group consisting of methyl, ethyl, t-butyl, methoxy, ethoxy, phenyl, biphenyl, terphenyl, phenylethenyl, diphenylethenyl, naphthyl, anthryl, phenanthryl, fluorenyl, pyrenyl, benzyl, pyridyl, carbazolyl, benzimidazolyl, quinolyl and quinoxalyl, and the other two A's are independently phenyl, naphthyl, anthryl, phenanthryl or a group, with one to four hydrogen on a group selected from these groups being optionally replaced with at least one member selected from the group consisting of methyl, ethyl, t-butyl, methoxy, ethoxy, phenyl, biphenyl, terphenyl, phenylethenyl, diphenylethenyl, naphthyl, anthryl, phenanthryl, fluorenyl, pyrenyl, benzyl, pyridyl, carbazolyl, benzimidazolyl, quinolyl and quinoxalyl.

41. A phosphorescent device according to any one of claims 36 to 40, wherein two A's are bonded at the 9- and 10-positions of Ant.

42. A phosphorescent device according to any one of claims 30 to 35, wherein two A's have each independently one or two substituents which are independently biphenyl, terphenyl, phenylethenyl, diphenylethenyl, naphthyl, anthryl, phenanthryl, fluorenyl or pyrenyl.

43. A phosphorescent device according to any one of claims 36 to 41, wherein three A's have each independently one or two substituents which are independently biphenyl, terphenyl, phenylethenyl, diphenylethenyl, naphthyl, anthryl, phenanthryl, fluorenyl or pyrenyl.

44. A phosphorescent device according to claim 3, wherein in formula (F11), t=2 and two A's are each independently phenyl, naphthyl, anthryl, phenanthryl, fluorenyl or pyrenyl, and have each independently one or two substituents which are independently biphenyl, terphenyl, phenylethenyl, diphenylethenyl, naphthyl, anthryl, phenanthryl, fluorenyl or pyrenyl.

45. A phosphorescent device according to claim 3, wherein in formula (F11), t= 3 and three A's are each independently phenyl, naphthyl, anthryl, phenanthryl, fluorenyl or pyrenyl, and have each independently one or two substituents which are independently biphenyl, terphenyl, phenylethenyl, diphenylethenyl, naphthyl, anthryl, phenanthryl, fluorenyl or pyrenyl.
